**Europäisches Patentamt**

**European Patent Office**

**Office européen des brevets**

(19)

(11) **EP 1 333 505 A2**

(12) **EUROPEAN PATENT APPLICATION**

(43) Date of publication:
06.08.2003 Bulletin 2003/32

(51) Int Cl.7: **H01L 39/24**, G01R 33/035

(21) Application number: 03250461.5

(22) Date of filing: 24.01.2003

(84) Designated Contracting States:
**AT BE BG CH CY CZ DE DK EE ES FI FR GB GR HU IE IT LI LU MC NL PT SE SI SK TR**
Designated Extension States:
**AL LT LV MK RO**

(30) Priority: 25.01.2002 US 351781 P

(71) Applicant: **The University Of Maryland**
**College Park, MD 20742-9520 (US)**

(72) Inventors:
 • **Venkatesan, Thirumalai**
  **Washington, DC 20008 (US)**
 • **Ming, Bing**
  **College Park, Maryland 20740 (US)**
 • **Vispute, Ratnakar D.**
  **Columbia, Maryland 21045 (US)**

(74) Representative: **Harris, Ian Richard et al**
 **D. Young & Co.,**
 **21 New Fetter Lane**
 **London EC4A 1DA (GB)**

(54) **High performance step-edge squids on a sapphire substrate and method of fabrication**

(57) YBCO step-edge junctions and SQUID on sapphire substrates using $CeO_2$ as a buffer layer are fabricated. A steep step-edge is formed in the $CeO_2$ buffer layer by the $Ar^+$ ion milling of the buffer layer over a shadow mask having an overhang end structure which allows for an extended time of milling for forming a deep steep step-edge within the buffer layer. The step angle is greater than 81° as measured by AFM. A high quality YBCO film is then epitaxially grown by pulse laser deposition. After patterning, the junctions display RSJ-type I-V characteristics. The sapphire based YBCO step-edge SQUIDs are installed onto a SQUID microscope system. SQUIDs fabricated by the step-edge technique exhibit excellent magnetic field modulation, high imaging qualities, and low noise.

FIG.21

**Description**

FIELD OF THE INVENTION

The present invention relates to high performance superconductor quantum interference devices (SQUIDs) and to the fabrication of step-edge junctions on a sapphire substrate for such SQUIDS.

BACKGROUND OF THE INVENTION

Superconductor quantum interference devices (SQUIDs) are currently known to be the most sensitive sensors for magnetic signals. SQUIDs have found wide ranging applications in such areas as biomagnetism, geophysics, and non-destructive evaluation measurement systems. In particular, scanning SQUID microscopy has been increasingly viewed as an indispensable tool in the semiconductor industry. High-$T_c$ junction technologies are the basis for manufacturing of SQUIDs. To date, most commercial applications have used bicrystal junctions made on STO ($SrTiO_3$) and LAO ($LaAlO_3$) substrates. Though easy to fabricate junctions on such substrates, junction location is restricted to the substrate grain boundary, thus creating a deficiency in topological freedom which makes it extremely difficult to fabricate complex circuits. Additionally, the bicrystal substrates are costly and increases the fabrication manufacturing costs.

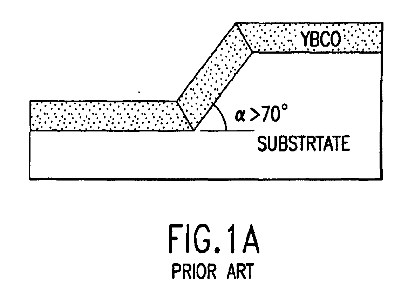

Step-edge junctions are known to provide topological freedom and thus are advantageous over the bicrystal junctions in significantly increased device yield and fabrication of the complex circuits. Step-edge junctions are usually patterned by standard lithography and $Ar^+$ ion milling in order that their locations may be chosen at the discretion of the user. (R. Simon, et al., IEEE Transmagn, 27, 3209 (1991)). In step-edge junctions, the substrate is patterned by standard lithography and the step-edge is ion milled in order to form an angle with the plane $\alpha$, shown in Fig. 1, which has a major influence on the junction characteristics after fabrication. The junction is formed on the step-edge between the substrate and the YBCO film deposited on the step-edge. Detailed microstructure studies (C.L. Jia, et al., Physica C., 175, 545 (1991); C.L. Jia, Physica C., 196, 211 (1992); and K. Herrmann, et al., J. Applied Physics, 78, 1131 (1995)) show that very steep steps with $\alpha > 70°$ are desired for good junction performance. However, preparation of such step-edges is non-trivial for perovskite substrates such as STO and LAO. This is due to the fact that during prolonged ion milling process, the mask material created by the standard lithography process on the surface of the substrate inevitably erodes at the edge, resulting in a shallow step-edge profile in the substrate.

The step-edge junction characteristics are importantly dependent upon the processing parameters as well as the choice of the substrate. The preparation of well-defined, microstructurally reproducible steps is a prerequisite of high quality junctions. Sapphire substrates are an advantageous choice for the substrate, since R plane sapphire ($1\bar{1}02$ orientation) combines outstanding crystalline perfection, mechanical strength, low dielectric constant and low losses with availability of large area substrates at low cost. In addition, they have a high thermal conductivity at low temperature that makes them particularly suitable for the operation of scanning SQUID microscopes. As compared to other commonly used substrates, such as STO and LAO, sapphire is particularly suitable for high frequency microwave applications, due to its low dielectric constant ($\varepsilon \approx 9$) and low losses ($\tan\delta < 10^{-4}$). Large area sapphire substrates are readily available commercially. In addition, in the temperature range of 70-90K, sapphire has a very high thermal conductivity, more than 20 times that of LAO. This provides a significant advantage in technology applications of high temperature superconducting devices at operating temperatures, such as optical mixers and scanning SQUID microscopy. Unfortunately, with regard to ion milling, sapphire is even more difficult to process directly since sapphire has one of the lowest milling rates of all materials.

It therefore would be desirable to fabricate high performance step-edge high-$T_c$ superconductor quantum interference device on a sapphire substrate but with the provision of allowing an enhanced milling rate resulting in better edge definition.

SUMMARY OF THE INVENTION

Aspects of the invention are defined in the accompanying claims.

An embodiment of the invention can provide a technique for fabrication of step-edge junctions on sapphire substrates with enhanced ion milling procedure for creation of extremely steep and well-defined step-edges.

An embodiment of the invention can provide a technique for step-edge Josephson junction fabrication on sapphire substrates by pulse laser deposition of a buffer layer on the sapphire substrate producing an "overhang" shadow mask by a novel photolithography technique, as well as ion milling of a steep step-edge in the buffer layer, where the step angle is in excess of 80°. A high quality YBCO film is then deposited over the step-edge by PLD for creation of step-edge Josephson junctions.

An embodiment of the invention can provide a technique for fabrication of step-edge SQUIDs on a sapphire substrate where a buffer layer on the sapphire substrate is milled by means of ion milling procedures with optimized parameters for minimum ion beam divergence for manufacturing well-defined steep step-edges.

According to one aspect of the invention, a process of the step-edge superconductor quantum interference device on the sapphire substrate includes the steps of:

growing a buffer layer on an upper surface of the sapphire substrate,
at a predetermined location of the upper surface of the buffer layer, creating a shadow mask having an overhang end,
directing an ion beam towards the upper surface of the buffer layer at the overhang end of the shadow mask,
ion milling the buffer layer with the ion beam to create a step-edge in the buffer layer, and
growing a YBCO layer on the step-edge.

The buffer layer is preferably grown by pulse layer deposition techniques on the sapphire substrate. The shadow mask having the overhang end is created by photolithographic procedure. The shadow mask may be an AZ5214E photoresist hardened by chlorobenzene treatment and baking.

The YBCO layer is grown by pulsed laser deposition techniques at a temperature of 700-800°C and 150 mTorr ambient $O_2$ pressure, and preferably 100 nm thickness. During a pulsed laser deposition of the YBCO layer the laser produced plume is directed to the face of the step-edge.

The buffer layer may be epitaxially grown on the sapphire substrate and may include any material from the group of materials, including:

$CeO_2$, $SrTiO_3$, YSZ, $LaAlO_3$, MgO, $NdGaO_3$, PrBaCuO, $CaTiO_3$, $SrRuO_3$, $CaRuO_3$, $SnO_2$.

The buffer layer is preferably a $CeO_2$ film of 200-300 nm thickness deposited on the sapphire substrate at 500-850 C and $10^{-5}$T - 500 mT ambient $O_2$ pressure.

During the ion milling procedure, the ion beam having the minimized divergence is pointed substantially normal to the upper surface of the buffer layer, and due to an "overhang" end structure of the photoresist mask the step-edge is well-defined and the depths of the step-edge attained is not smaller than approximately 150 nm.

A good ohmic contact of Au (150 nm thickness) is pulsed laser deposited onto the YBCO layer, after which the structure is patterned by a photolithography technique and ion milling into individual step-edge Josephson junctions which are looped together and which cross the step-edge.

According to another aspect of the invention, there is provided a step-edge superconductor quantum interference device (SQUID), including:

a sapphire substrate,
a buffer layer grown on the upper surface of the sapphire substrate, where the buffer layer includes a step-edge formed at a predetermined location and extending substantially transversely through the buffer layer, and
a YBCO layer grown on the step-edge of the buffer layer which is patterned to form at least a pair of looped Josephson junctions with each crossing the step-edge.

The buffer layer is formed preferably of $CeO_2$ of 20-300 nm thickness, however it may also be fabricated of any material compatible with the YBCO layer which adapted epitaxially growth on the sapphire substrate.

The thickness of the YBCO layer is preferably approximately 50-200 nm with the height of the step-edge being approximately 150 nm.

The SQUID further includes a layer of Au of approximately 150 nm, pulse laser deposited onto the YBCO layer, which forms the ohmic contact. The YBCO layer is further patterned into at least a pair of individual Josephson junctions each having a width of approximately 3 microns.

Thus an embodiment of the invention can provide for the fabrication of sapphire-based YBCO step-edge SQUIDs using a buffer layer deposited onto the substrate, creation of the steep step-edge in the buffer layer, pulse laser deposition of high quality YBCO film onto the step-edge of the buffer $CeO_2$ layer, and patterning the YBCO film into single step-edge junctions crossing the step-edge.

Step-edge junctions can be formed over a step-edge manufactured in a buffer layer by a novel photolithography masking technique and subsequent ion milling with optimized parameters.

These and other features and advantages of this invention will be fully understood from the following description and drawings.

BRIEF DESCRIPTION OF DRAWINGS

FIG. 1 is a schematic representation of a step-edge junction fabrication according to the prior art;
FIGS. 2A-2I schematically show a sequence of operation for fabrication of the step-edge SQUID on the sapphire substrate according to an example of the present invention;
FIG. 3A is a SEM picture of the photoresist shadow mask with the "overhang" structure;
FIG. 3B is a diagram showing AFM section analysis of the step-edge created by ion milling on the $CeO_2$ layer;
FIG. 4A is a diagram showing X-ray diffraction patterns of an YBCO film on $CeO_2$ buffered R-plane (IT02) sapphire (the capitals S, B and Y denote the substrate, $CeO_2$ buffer layer and YBCO film, respectively);
FIG. 4B illustrates X-ray φ-scan patterns taken from a YBCO film on $CeO_2$ buffered R-plane (IT02) sapphire;

FIG. 5A is a diagram showing a typical step-edge junction I-V curve at 77K ($I_c$ = 80 μA, $R_n$ = 3.2 ohm);

FIG. 5B is a diagram showing junction Shapiro steps under microwave irradiation at 77K (F = 17.9 GHz, $\Delta V \simeq$ 36 μV);

FIG. 6 is a diagram showing step-edge junction critical current modulation with magnetic field applied normal to the substrate plane (the dotted line is a theoretical fit to a short junction);

FIG. 7 represents schematically a single SQUID after dicing, ready to be mounted onto a SQUID microscope system;

FIG. 8 illustrates an I-V diagram of the SQUID of the present invention mounted onto the SQUID microscope system;

FIG. 9 is a diagram representing magnetic modulation of step-edge SQUID voltage at 77K;

FIG. 10 is a diagram representing noise measurements of the step-edge SQUID of the present invention; and

FIGS. 11A-11C schematically illustrate an example of a technique for minimizing ion beam divergence, wherein: FIG. 11A shows an annular metal mask created for measurement of the ion beam divergence; FIG. 11B is a cross-section of the annular metal mask taken along Lines A-A, and FIG. 11C shows a visible annular ring on the silicon surface.

DETAILED DESCRIPTION

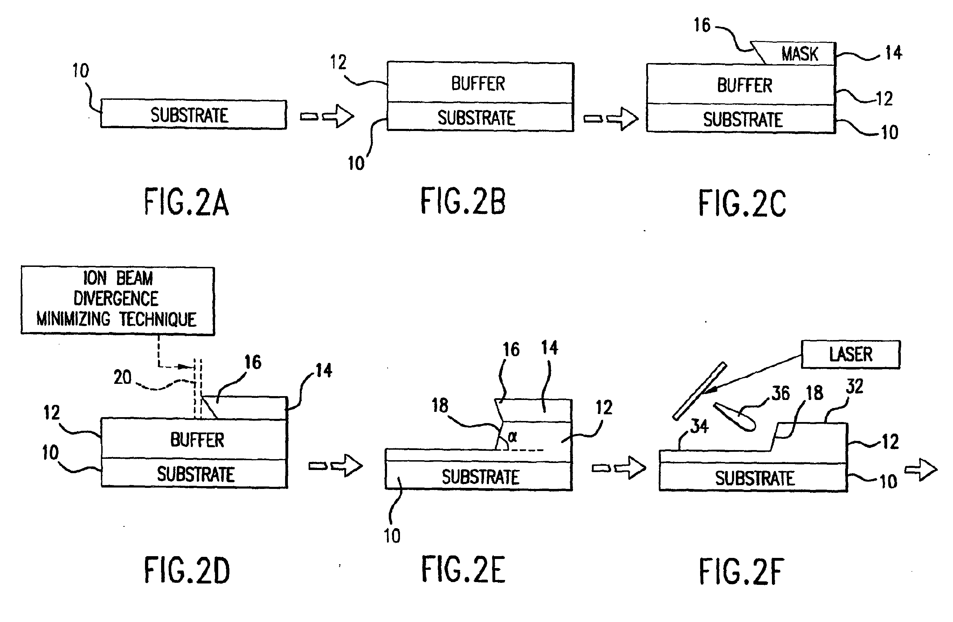

The technique for fabrication of high performance step-edge high-$T_c$ superconductor quantum interference devices (SQUIDs) on the sapphire substrate is schematically illustrated by Figures 2A-2I showing the sequence of manufacturing steps. Referring to Figure 2A, a substrate 10 is made of sapphire. Sapphire is an ideal substrate for high-$T_c$ junction technology. Sapphire of R-plane ($1\bar{1}02$) orientation is an excellent substrate for fabrication of thin film devices, for example, $YBa_2Cu_3O_{7-\delta}$ thin film devices, since the sapphire as the substrate material possesses superior crystalline perfection, mechanical strength, and is available at low cost. Sapphire is particularly suitable for high frequency microwave applications, due to its low dielectric constant ($\varepsilon \approx 9$) and low losses ($\tan\delta < 10^{-4}$). In addition, in the temperature range of 70-90K, sapphire has a very high thermal conductivity at low temperatures that makes it particularly suitable for operation of scanning SQUID microscopes.

Referring to Figure 2B, a buffer layer 12 was formed on the surface of the sapphire substrate 10 by a pulsed laser deposition (PLD) technique. Preferably, the buffer layer 12 is an etch-friendly $CeO_2$ layer. However, alternative candidates for the buffer layer include $SrTiO_3$, Yttria Stabilized Zirconia (YSZ), $LaAlO_3$, MgO, $NdGaO_3$, PrBaCuO, $CaTiO_3$, $SrRuO_3$, $CaRuO_3$, $SnO_2$,

i.e., any films that can grow epitaxially on sapphire material and additionally which provide good basis for YBCO. Particularly, using KrF pulsed laser deposition, the $CeO_2$ having thickness of 20-300 nm, is first deposited on the sapphire substrate 10 at 500-850°C and at the ambient $O_2$ pressure in the range of $10^{-5}$T to 500 mTorr. The technique is well-known to those skilled in the art and therefore is not intended to be discussed in further detail.

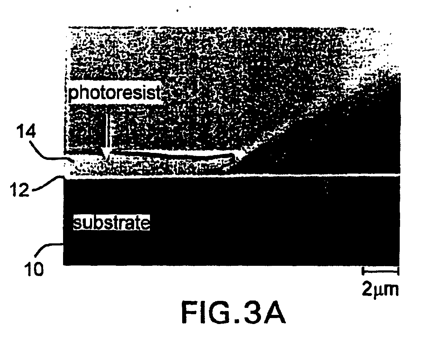

Referring to Figure 2C, after the $CeO_2$ buffer layer 12 was deposited by PLD, the structure is patterned by photolithography procedure to create a photoresist shadow mask 14 (also shown in Figure 3A). A novel photolithography procedure was developed to create a photoresist mask of AZ5214E having a particular "overhang" end structure 16, which is best shown in Figures 2C-2E and 3A. After the overhang end structure 16 has been created, the photoresist is hardened by chlorobenzene treatment and baking. The key to making such an overhang resist structure are the following steps:

1. Coat the sample with photoresist and spin as in regular photolithography;
2. "Soft bake" the photoresist in the oven at 60-90°C;
3. Apply Chlorobenzene for 3-20 min;
4. Develop at length until the exposed areas are clear;
5. Apply Chlorobenzene again for 5-10 min;
6. "Hard bake" the sample at 90-120°C for 5-15 minutes;
7. The key for controlling the shape and height of the "overhang" is varying the Chlorobenzene treatment time and temperature and time of baking.

Such an overhang end structure 16 of the shadow mask 14 is particularly designed for enhancement of the subsequent ion milling operation by which the step-edge 18 of the well-defined profile and needed depths is created. Without such an overhang end structure 16, in the subsequent ion milling operation, the prolonged ion milling which inevitably erodes the edge of the shadow mask, may result in a shallow step profile unwanted for step-edge junctions.

Thus, the overhang end structure 16 of the shadow mask 14 even being affected by the ion milling process, shown schematically in Figure 2D, still permits substantial time and optimum conditions for the ion milling procedure to create a well-defined steep step profile of the step-edge 18.

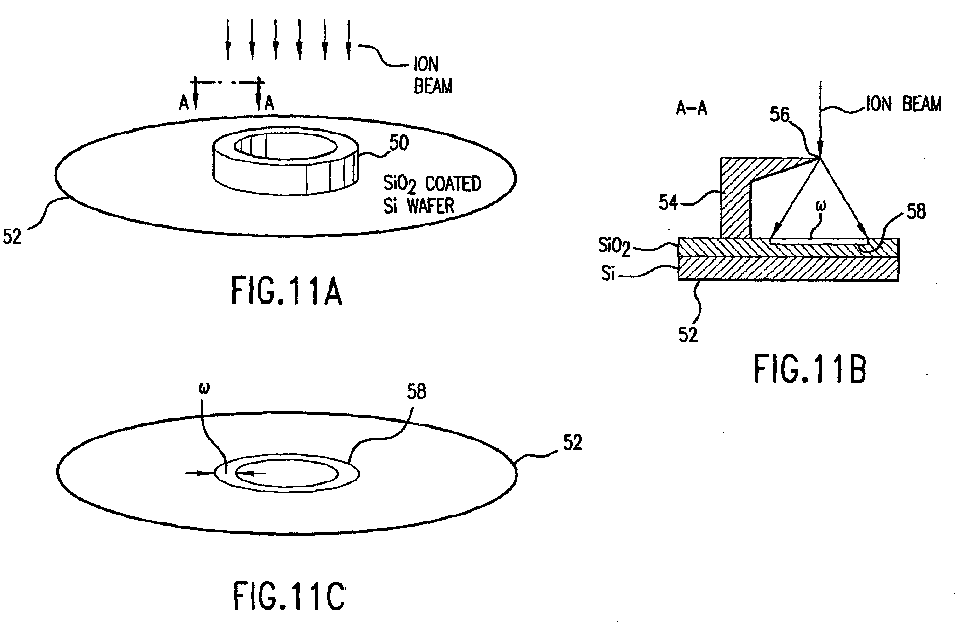

As shown in Figure 2D, in the $Ar^+$ ion milling operation, an ion beam 20 is directed normal to the sample over the overhang end structure 16. Provisions are made to minimize beam divergence as will be described in detail further herein with regard to FIGS. 2D and 11A-11C. During ion milling, the ion beam 20 erodes the portion of the overhang end structure 16, while simultaneously producing a step-edge 18 in the buffer layer 12. The quality of the step-edge 18 depends greatly on how quickly the overhang end structure 16 is eroded and how long the shadow mask 14 can provide protection for those portions of the buffer layer 12 which are not to be milled out. Responsive to the overhang end structure 16 being created, the shadow mask 14 provides an extended protection corresponding to the time needed to erode the overhang end structure 16. This permits the milling of a deep and steep step-edge 18 in the buffer layer 12.

During the ion milling, it is extremely important to keep the divergence of the ion beam 20 as minimal as possible. In order to minimize the beam divergence, the ion beam divergence minimizing technique is performed, best shown in FIGS. 2D and 11A-11C. Prior to performing the ion milling (shown in FIG. 2D), the divergence of the ion beam 20 is measured by means of a circular metal mask 50 shown in FIG. 11A. The circular metal mask 50 (made of nickel, molybdenum, etc.) with a height of 0.5 cm, diameter of 2 cm, and an annular width of 0.5 cm is placed on a $SiO_2$ coated silicon wafer 52 and ion milled. The cross-section 54, shown in FIG. 11B, of the annular metallic ring mask 50 is designed to have a sharp inner lip 56. Once the $SiO_2$ layer of the silicon wafer 52 is ion milled with the ion beam, this creates a visible annular ring 58, as shown in FIGS. 11B and 11C, on the silicon surface of the wafer 52. When silicon is covered by $SiO_2$ depending on the thickness of $SiO_2$ layer, different interference colors can be seen. This enables one to see the etched region clearly. The width $\omega$ of the ring 58 depends on the divergence of the ion beam, as best shown in FIG. 11B. When the ion beam divergence is minimum, then the annular width $\omega$ of the ring 58 is also a minimum. Thus, the divergence of the ion beam can be judged by the width of the ring 58, that provides a simple way to measure the ion beam divergence. Therefore, prior to the ion milling procedure, shown in Figure 2D, the divergence of the ion beam 20 is measured by means of the technique shown in Figures 11A-11C, and once the minimal divergence of the ion beam is attained, it is kept this way during the ion milling of the buffer layer.

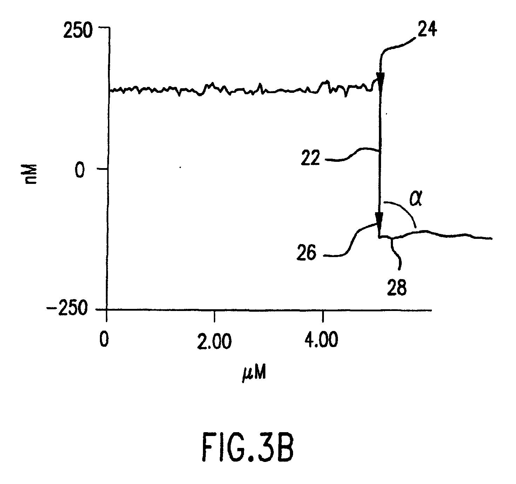

As best shown in Figures 2E and 3B, the step angle $\alpha$ is larger than 80° after fabrication. Particularly seen in Figure 3B, showing the diagram of AFM section analysis of the step-edge 18 created by the ion milling on the $CeO_2$ buffer layer 12, the edge line portion 22 between two markers 24 and 26 is an 81.244° angle to the horizontal line 28 (the scales for vertical and horizontal direction of the diagram showing on Figure 3B are different). It is to be noted however that since the measurement of the AFM tip itself has a forward scanning half angle of 11° and cannot measure step angles higher than 80°, the real step produced is considered as being substantially vertical. The step height shown in Figure 3B is 150 nm.

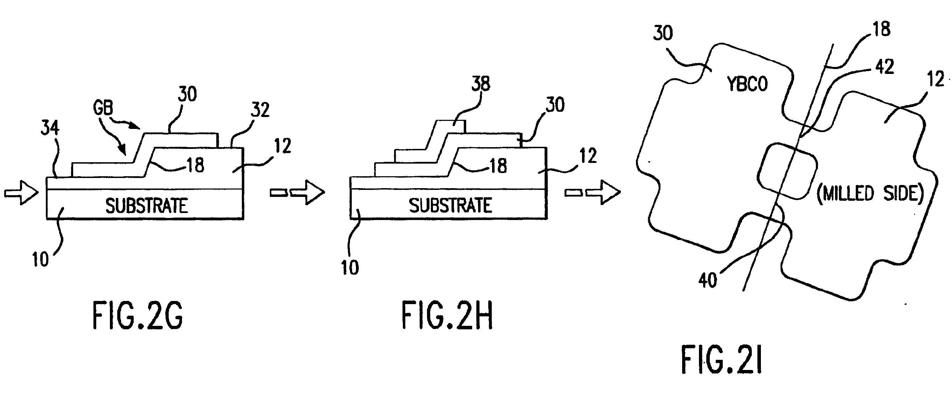

Shown further in Figures 2F and 2G, a 50-200 nm thick YBCO film 30 is next grown by the PLD technique on the step edge 18 (as well as on the upper surface 32 of the buffer layer 12 and a horizontal surface 34 milled in the buffer layer 12). When the YBCO film is grown over the underlying step edge, grain boundary (GB) weak links are formed and they create superconducting Josephson junctions. The junction behavior depends importantly on the step-edge and in order to obtain junctions for high performance SQUIDs, the step height has to be at the proper ratio with the film thickness, with the step slope being as close to vertical to the substrate as possible. Additionally, for the growth of YBCO film, the $CeO_2$ buffer layer is well-suited to reduce the lattice mismatch and to prevent the diffusion of aluminum from the sapphire substrate into YBCO films at high temperatures. The YBCO film 30 is grown by PLD on the buffer layer 12 at the deposition temperature 700-800°C and the ambient $O_2$ pressure of 5-200 mTorr. The laser produced plume 36 (best shown in Figure 2F) is pointed into the step-edge face instead of being normal to the buffer layer 12 to improve yield of high quality Jefferson junctions.

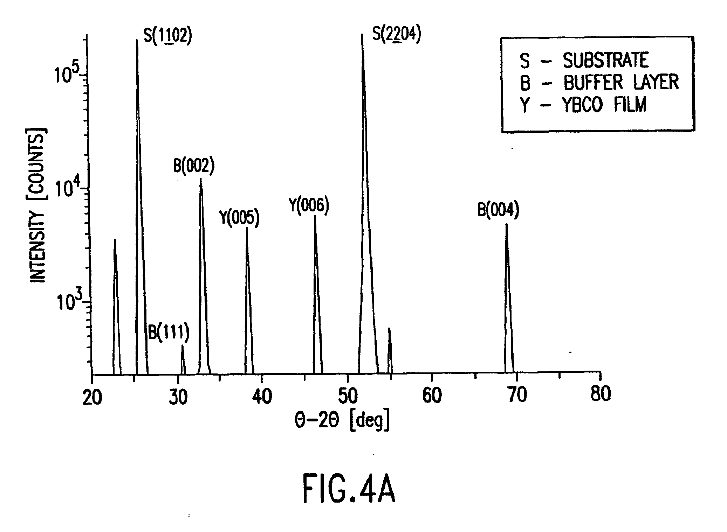

The YBCO films made in this manner has critical temperatures ($T_c$) of 88-89 K as measured by the inductive method, and $\Delta T_c \approx 0.2$ K. The critical current density ($J_c$) of the YBCO films are approximately 4.0 x $10^6$ A/cm². Standard θ-2θ X-ray diffractometry is used to determine the crystallinity and epitaxy of the YBCO film made after the ion milling process, as shown in FIG. 4A. The (111) peak of the $CeO_2$ film has been found to be effectively suppressed as against the (002) peak. As a result, the YBCO film exhibits a well-oriented (001) structure with no peaks of either a-axis oriented grains or other foreign phases.

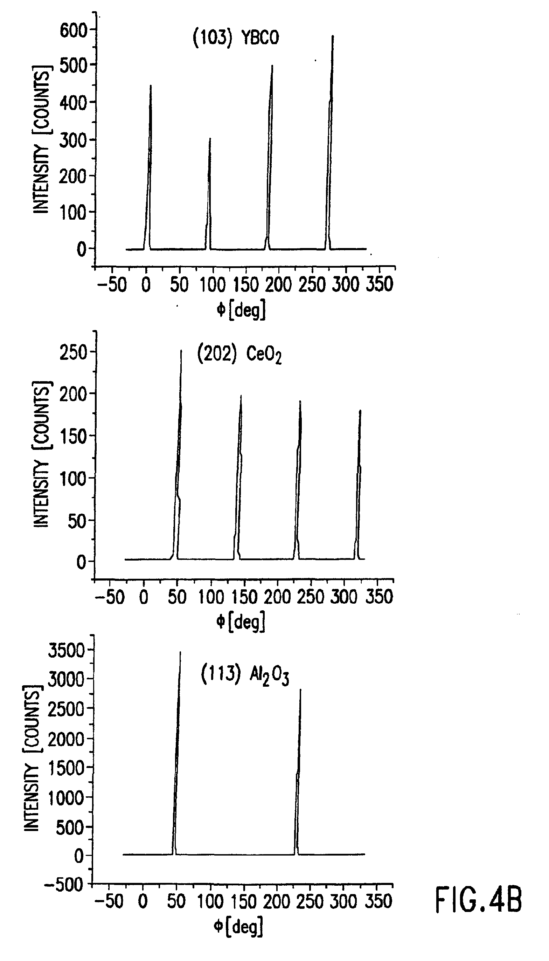

The full width at half-maximum (FWHM) of the (005) YBCO examined by ω-scan (rocking curve) has been found to be 0.52°. The in-plane orientation of the YBCO films was studied by φ-scan on the (103) YBCO diffraction peak, as shown in FIG. 4B. The fourfold symmetry exhibits the 90° twinning in the a-b plane and no 45° misoriented grains were observed. The high quality of the YBCO film thus indicates that very little damage is incurred during the ion milling process.

Further, for good ohmic contact, Au film 38 of 150 nm thickness has been deposited *in situ* by PLD, as shown in FIG. 2H. The YBCO film 30 was then patterned into step-edge Josephson junctions 40 and 42 by standard photolithography and ion milling, as shown in FIG. 2I on a somewhat enlarged scale. Each junction 40 and 42 represents a micro-bridge crossing the step edge 18 with the junctions being approximately 3 μm in width.

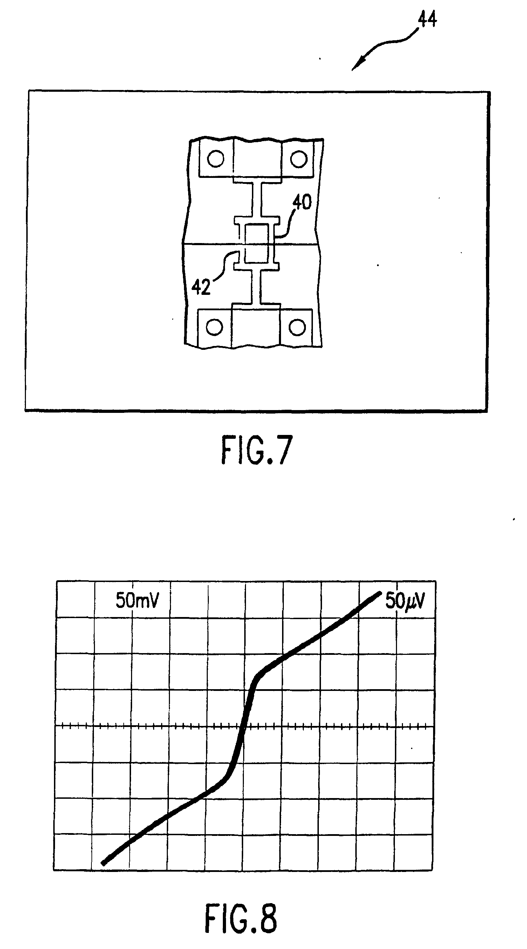

After dicing individual SQUIDs 44 (best shown in FIG. 7) from the sample substrate, they are mounted in a scanning SQUID microscope. Electrical measurements are made with a standard four-point probe technique. Microwave radiation is fed onto the sample with an antenna built into the probe.

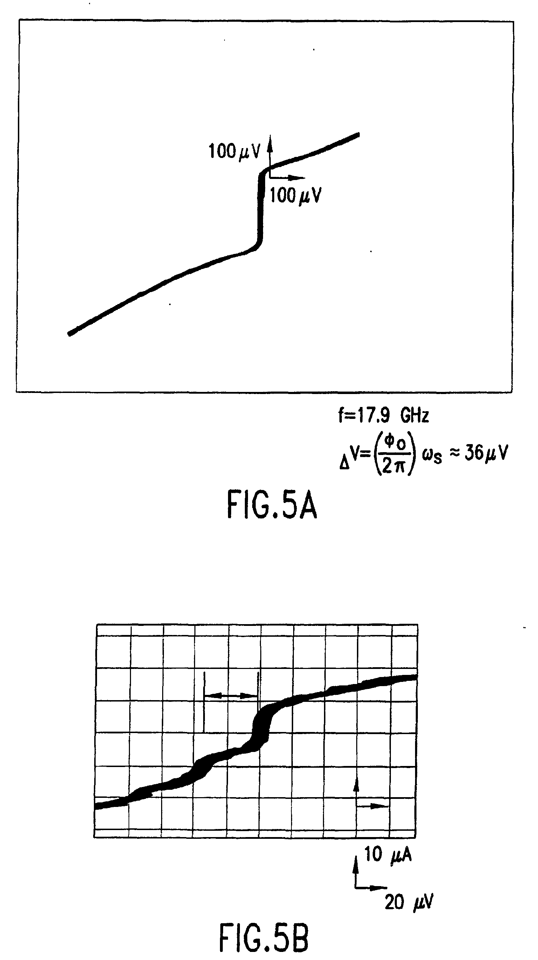

Referring to FIG. 5A, showing the typical current-voltage characteristics (I-Vs) of the junctions at 77 K, the I-V curves follow the shape of the resistively shunted junction (RSJ) model for temperatures from 4 K to 77 K. The $I_cR_n$ products at 77 K range from approximately 200 to 500 $\mu$V. The junctions demonstrated Shapiro steps under microwave irradiation. At 77 K, Figure 5B shows that at 17.9 GHz the steps occur at fixed voltage intervals of 36 $\mu$V, reflecting the Josephson nature of the junction.

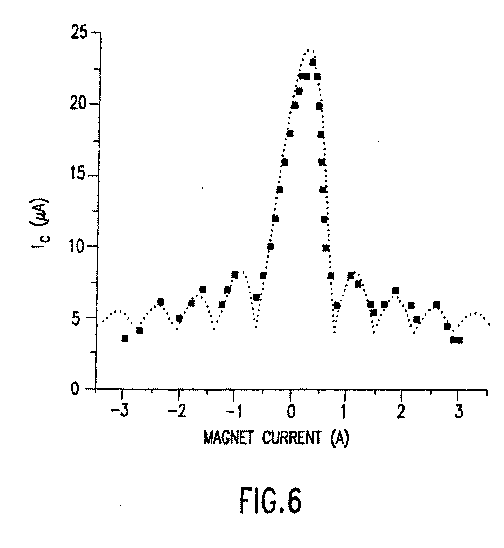

Under applied magnetic field, the critical current modulation is a stringent test of the junction current uniformity. As shown in FIG. 6, $I_c$ can be observed to be varying periodically and the modulation maxima and minima closely follow the description of an ideal Fraunhofer curve. The good current uniformity implies that the various junction fabrication processes are well controlled and the step-edge is relatively straight and free of microstructural defects.

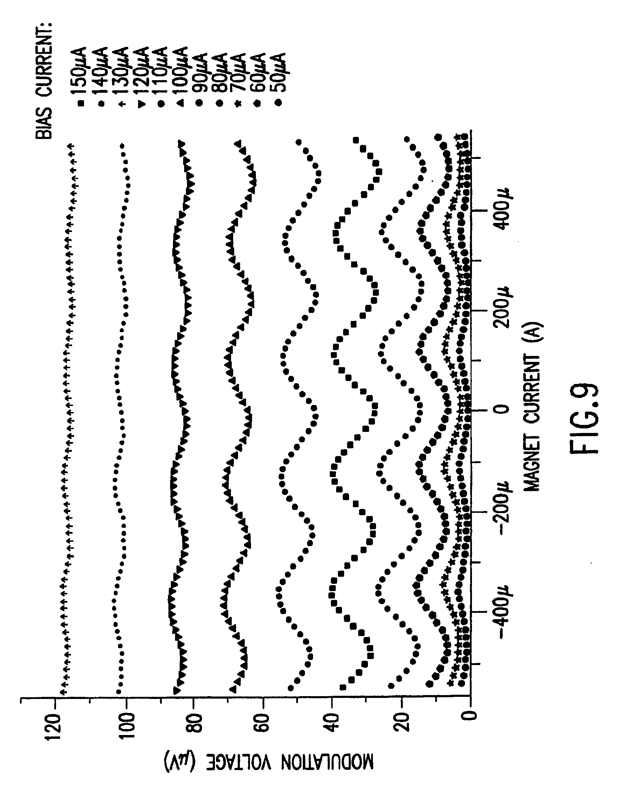

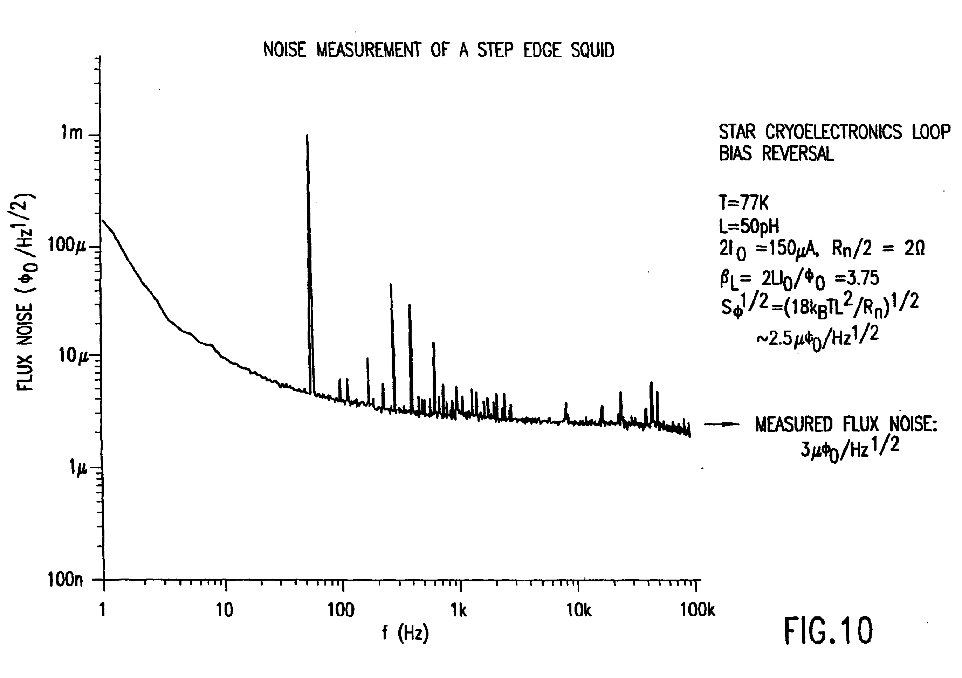

By the method of the present invention, $YBa_2Cu_3O_{7-\delta}$ step-edge junctions on sapphire substrates have been fabricated which after patterning exhibited RSJ-like current voltage characteristics. Single SQUID 44 after dicing, ready to be mounted onto the SQUID microscope, is shown in Figure 7. The mounted SQUID 44 has contact resistance only at 0.2 ohms as shown in Figure 8. SQUIDs 44 fabricated by the step-edge technique of the present invention exhibit excellent magnetic field modulation, as shown in Figure 9, and have a spectral density of white flux noise obtained at 77K as shown in Figure 10.

The sapphire base YBCO step-edge SQUIDs installed onto an Advanced Scanning SQUID microscope system has exhibited low noise and high imaging qualities. The SQUID tip was at ambient liquid nitrogen temperature and was separated from the room temperature test samples by a thin window. Integrated circuits with different circuit configurations and current paths were successfully imaged by scanning the magnetic field directly above the sample. The magnetic field information was then converted into a current density distribution.

Thus, in an embodiment of the invention, YBCO step-edge junctions and SQUID on sapphire substrates using $CeO_2$ as a buffer layer are fabricated. A steep step-edge is formed in the $CeO_2$ buffer layer by the $Ar^+$ ion milling of the buffer layer over a shadow mask having an overhang end structure which allows for an extended time of milling for forming a deep steep step-edge within the buffer layer. The step angle is greater than 81° as measured by AFM. A high quality YBCO film is then epitaxially grown by pulse laser deposition. After patterning, the junctions display RSJ-type I-V characteristics. The sapphire based YBCO step-edge SQUIDs are installed onto a SQUID microscope system. SQUIDs fabricated by the step-edge technique exhibit excellent magnetic field modulation, high imaging qualities, and low noise.

Although this invention has been described in connection with specific forms and embodiments thereof, it will be appreciated that various modifications other than those discussed above may be resorted to without departing from the scope of the invention. For example, equivalent elements may be substituted for those specifically shown and described, certain features may be used independently of other features, and in certain cases, particular locations of elements may be reversed or interposed, all without departing from the scope of the claimed invention.

## Claims

1. A method for fabrication of step-edge junctions on a sapphire substrate, comprising the steps of:

   preparing a sapphire substrate (10),
   growing a buffer layer (12) of an upper surface of said sapphire substrate,
   creating a shadow mask (14) having an overhang end at a predetermined location of an upper surface of said buffer layer,
   directing an energy beam (20) towards said upper surface of said buffer layer at said overhang end of said shadow mask,
   milling said buffer layer with said energy beam to create a step-edge (18) in said buffer layer, and
   growing a YBCO layer (30) on said step-edge.

2. The method of Claim 1, wherein said buffer layer is epitaxially grown on said upper surface of said sapphire substrate.

3. The method of Claim 1 or Claim 2, wherein said buffer layer is grown by Pulsed Laser Deposition technique.

4. The method of any preceding Claim, wherein said buffer layer is formed of a material compatible with YBCO and sapphire.

5. The method of any preceding Claim, wherein said buffer layer is formed of a material from a group of materials, including: $CeO_2$, $SrTiO_3$, Yttria stabilized zirconia (YSZ), $LaAlO_3$, MgO, $NdGaO_3$, PrBaCuO, $SrRuO_3$, $CaRuO_3$, $SnO_2$, and $CaTiO_3$.

6. The method of any preceding Claim, wherein said buffer layer is a $CeO_2$ film of the thickness in the range of 20 nm - 300 nm deposited on said sapphire substrate at the temperature in the range of 500-850°C and at the ambient $O_2$ pressure in the range of $10^{-5}$ T - 500 mTorr.

7. The method of any preceding Claim, wherein said shadow mask with said overhang end is created by photolithographic procedure.

8. The method of any preceding Claim, wherein said energetic beam is the Ar$^+$ ion beam.

9. The method of any preceding Claim, further comprising the steps of:

directing said energetic beam substantially normal to said upper surface of said buffer layer during said milling thereof.

10. The method of any preceding Claim, wherein said YBCO layer is grown by Pulsed Laser Deposition technique.

11. The method of Claim 10, further comprising the step of:

pointing a laser produced plume to a face of said step-edge during said Pulse Laser Deposition.

12. The method of any preceding Claim, further comprising the steps of:

growing said YBCO layer of the thickness in the range of 50-200 nm at the deposition temperature in the range of 700-800°C and the ambient O$_2$ pressure in the range of 50-200 mTorr.

13. The method of any preceding Claim, wherein said shadow mask includes a AZ5214E photoresist hardened by chlorobenzene treatment and baking.

14. The method of any preceding Claim, wherein said step-edge is substantially vertical towards said upper surface of said buffer layer.

15. The method of any preceding Claim, further comprising the steps of:

patterning said YBCO layer into a plurality of step-edge junctions by photolithography and ion milling.

16. The method of any preceding Claim, further comprising the steps of:

minimizing divergence of said energy beam.

17. The method of any preceding Claim, further comprising the steps of:

creating an annular metal mask on a silicon wafer coated with SiO$_2$ layer, the cross-section of said annular metal mask having a sharp inner lip,

milling said SiO$_2$ layer with said energy beam, thus creating a visible annular ring on the surface of said silicon wafer, said visible annular ring having a width thereof, and determining the divergence of said energy beam based on said width of said visible ring.

18. A step-edge superconductor quauntum interference device (SQUID) comprising:

a sapphire substrate (10),
a buffer layer (12) grown on an upper surface of said sapphire substrate,
said buffer layer including a step-edge (18) formed at a predetermined location thereof and extending substantially transversely through said buffer layer, and
a YBCO layer (30) grown on said step-edge of said buffer layer and patterned to form at least a pair of looped Josephson junctions, each said Josephson junction crossing said step-edge.

19. The step-edge SQUID of Claim 18, wherein said buffer layer is formed of a material from the group of materials including CeO$_2$, SrTiO$_3$, yttria stabilized zirconia (YSZ), LaAlO$_3$, Mgo, NdGaO$_3$, PrBaCuO, SrRuO$_3$, CaRuO$_3$, SnO$_2$, and CaTiO$_3$.

20. The step-edge SQUID of Claim 18 or Claim 19, wherein said buffer layer is grown by Pulsed Laser Deposition technique.

21. The step-edge SQUID of any of Claims 18 to 20, wherein said YBCO layer is grown by Pulsed Laser Deposition.

22. The step-edge SQUID of any of Claims 18 to 21, wherein the thickness of said buffer layer is in the range of 20-300 nm.

23. The step-edge SQUID of any of Claims 18 to 22, wherein the thickness of said YBCO layer is in the range of 50-200 nm.

24. The step-edge SQUID of any of Claims 18 to 23, wherein the height of said step-edge is 150 nm.

25. The step-edge SQUID of any of Claims 18 to 24, further comprising an ohmic contact including 150 nm thick layer of Au Pulsed Laser Deposited onto said YBCO layer.

26. The step-edge SQUID of any of Claims 18 to 25, wherein the width of each said Josephson junction is 3 μm.

FIG.1A
PRIOR ART

FIG.2A

FIG.2B

FIG.2C

FIG.2D

FIG.2E

FIG.2F

FIG.2I

FIG.2H

FIG.2G

FIG.3A

FIG.3B

FIG.4A

EP 1 333 505 A2

FIG.4B

$$f = 17.9 \text{ GHz}$$

$$\Delta V = \left(\frac{\phi_0}{2\pi}\right) \omega_S \approx 36 \mu V$$

FIG.5A

10 µA

20 µV

FIG.5B

FIG.6

FIG.7

FIG.8

FIG.9

NOISE MEASUREMENT OF A STEP EDGE SQUID

STAR CRYOELECTRONICS LOOP
BIAS REVERSAL

$T = 77K$
$L = 50pH$
$2I_0 = 150\mu A$, $R_n/2 = 2\Omega$
$\beta_L = 2LI_0/\Phi_0 = 3.75$
$S_\Phi^{1/2} = (18 k_B T L^2/R_n)^{1/2}$
$\quad \sim 2.5 \mu\Phi_0/Hz^{1/2}$

⟶ MEASURED FLUX NOISE:
$3\mu\Phi_0/Hz^{1/2}$

FIG.10

EP 1 333 505 A2

**FIG.11A**

ION BEAM

A—A

56

ION BEAM

54

$SiO_2$

Si

52

**FIG.11B**

ω

58

52

**FIG.11C**

50

$SiO_2$ COATED Si WAFER

52

EP 1 333 505 A2